# FASCICULE DE BREVET EUROPEEN

(11) **EP 2 014 803 B1**
(45) Date de publication et mention de la délivrance du brevet: **08.02.2012**
(21) Numéro de dépôt: 08354045.0
(22) Date de dépôt: 26.06.2008
(51) Int. Cl.: C30B 11/00, C30B 29/06

(54) **Dispositif de fabrication d'un bloc de matériau cristallin avec modulation de la conductivité thermique**
Vorrichtung zur Herstellung eines Blocks aus kristallinem Material mit Modulation der Wärmeleitfähigkeit
Device for manufacturing a block of a crystalline material with modulation of its thermal conductivity

(30) Priorité: 10.07.2007 FR 0704979
(43) Date de publication de la demande: 14.01.2009
(73) Titulaire: Commissariat à l'Énergie Atomique et aux Énergies Alternatives, 75015 Paris (FR)
(72) Inventeur: Servant, Florence, 38000 Grenoble (FR); Camel, Denis, 73000 Chambéry (FR); Marie, Benoît, 38100 Grenoble (FR); Ponthenier, Damien, 38800 Champagnier (FR)
(74) Mandataire: Hecké, Gérard

(56) Documents cités:
- EP-A- 0 141 999
- EP-A- 0 889 148
- WO-A-2004/094704
- DE-A1- 3 323 896
- GB-A- 2 041 236
- JP-A- 2001 048 696

## Description

### Domaine technique de l'invention

L'invention est relative à un dispositif de réalisation d'un bloc de matériau cristallin à partir d'un bain de matériau fondu, comportant un creuset ayant un fond, des moyens d'extraction de la chaleur disposés sous le creuset et des moyens de modulation de la conductivité thermique interposés entre le fond du creuset et les moyens d'extraction de la chaleur

### État de la technique

Aujourd'hui, la production des cellules photovoltaïques est majoritairement réalisée à partir de silicium, le silicium étant lui-même majoritairement cristallisé dans des fours de type Czochralski ou Bridgman.

Dans une configuration de type Bridgman, la chaleur est apportée au creuset par le haut ou par les côtés et son extraction est réalisée par le bas. Le chauffage du four peut être réalisé selon plusieurs approches et notamment en ajustant la puissance de chauffage au fur et à mesure du procédé de cristallisation afin de faire avancer le front de cristallisation du silicium dans la phase liquide.

Un four de type Bridgman est particulièrement adapté à la réalisation de silicium pour l'industrie solaire car il permet notamment la réalisation de lingots multicristallins avec des grains colonnaires perpendiculaires au front de cristallisation.

Un four de type Bridgman permet également de contrôler le flux de chaleur extrait du creuset lors des trois phases du procédé d'élaboration :
- la fusion du silicium dans le creuset
- l'initiation de la croissance
- la cristallisation du lingot

Un four de type Bridgman permet encore de purifier le matériau utilisé par ségrégation des impuretés, qui sont alors rejetées dans la phase liquide. Cependant, pour purifier le matériau à solidifier, il est nécessaire de contrôler le flux de chaleur à extraire afin de rester dans des conditions de stabilité morphologique du front de solidification, ce qui peut limiter la vitesse de solidification.

Par ailleurs, lors de l'initiation de la croissance du silicium cristallin, il est également nécessaire d'augmenter de façon progressive le flux de chaleur extrait. Dans le cas contraire, une déstabilisation du front de croissance a lieu et empêche la bonne ségrégation des impuretés dans le silicium. De plus, l'initiation de la croissance, ou bien la reprise du germe, nécessite aussi le contrôle de la vitesse de solidification, et donc du flux de chaleur, pour assurer une bonne structure de grains.

Bien que les dispositifs de type Bridgman aient de nombreux aspects positifs, ils présentent cependant un certain nombre d'inconvénients notamment en ce qui concerne le contrôle précis de la température et des échanges calorifiques tout au long d'un cycle de cristallisation du silicium fondu.

Le brevet européen n° 141999 propose de retirer une partie isolante située sous le creuset, présente lors de la fusion du silicium, afin de diminuer l'isolation thermique au sein du creuset. Ainsi, tout en conservant une puissance de chauffage constante, une diminution de la température a lieu au moyen d'une libération accrue de la chaleur par rayonnement et la solidification est alors réalisée. Dans ce mode de réalisation, l'extraction de chaleur, par rayonnement, n'est pas réellement contrôlée, car la partie isolante sous le creuset est soit présente, soit enlevée.

Le document JP -A-2001048696 décrit également un refroidissement du silicium fondu en enlevant de façon progressive l'isolation située sous le creuset. Dans ce document, la modulation de la température a lieu par le contrôle du rayonnement. Cependant, ce mode de réalisation ne permet pas de contrôler finement la variation du flux de chaleur.

Ainsi, l'extraction du flux thermique du matériau fondu au sein du creuset par rayonnement présentant de nombreux inconvénients, l'extraction du flux thermique par conduction lui est généralement préférée.

Le document GB-A-2041236 décrit l'utilisation d'un tampon en graphite, placé sous le fond du creuset, qui permet d'augmenter la conductibilité thermique de l'ensemble et donc d'accroître l'extraction de chaleur par conduction. Cependant, ce bouchon de graphique étant situé au centre du fond du creuset, il refroidit de manière importante la partie centrale du cristal. Ainsi ce mode de réalisation ne s'applique pas à la fabrication de lingots de silicium de taille conséquente, puisque la quantité de chaleur qu'il faut extraire varie selon la résistance thermique du silicium solide, c'est-à-dire l'épaisseur de silicium, à traverser.

Le document EP-A-0889148 décrit un dispositif avec une plaque isolante qui peut être sous la forme de plusieurs plaques glissantes.

Le document WO-A-2004094704 décrit l'utilisation d'un creuset ayant principalement une extraction de la chaleur par rayonnement mais dont le dispositif utilise également une modulation de l'extraction de la chaleur par conduction au moyen de la compression d'un feutre de graphite situé sous le creuset.

Le document DE-A-3323896 décrit un dispositif avec un échangeur de chaleur sous forme d'empilement verticale des plaques de graphite.

### Objet de l'invention

L'objet de l'invention consiste à réaliser un dispositif de fabrication de bloc de matériau cristallin selon la revendication 1 qui module finement l'extraction de chaleur par conduction et qui soit facile à mettre en oeuvre.

Selon l'invention, ce but est atteint par un dispositif de fabrication selon les revendication annexées et plus particulièrement par le fait que les moyens de modulation de la conductivité thermique comportent une pluralité de plaques, en matériau thermiquement conducteur et peu émissif, parallèles au fond du creuset et des moyens de rapprochement et d'écartement desdites plaques les unes par rapport aux autres et par rapport au fond du creuset.

### Description sommaire des dessins

D'autres avantages et caractéristiques ressortiront plus clairement de la description qui va suivre d'un mode particulier de réalisation de l'invention donnés à titre d'exemple non limitatif et représenté aux dessins annexés, dans lesquels :
- les figures 1 et 2 représentent une vue schématique, en coupe, d'un mode de réalisation du dispositif selon l'invention respectivement lors de la phase de fusion et lors de la phase de cristallisation,
- la figure 3 représente une vue schématique, en coupe, d'une plaque (10) avec une surépaisseur au centre,
- la figure 4 représente une vue schématique, en coupe, d'une variante de réalisation du dispositif.

### Description d'un mode de réalisation préférentiel de l'invention

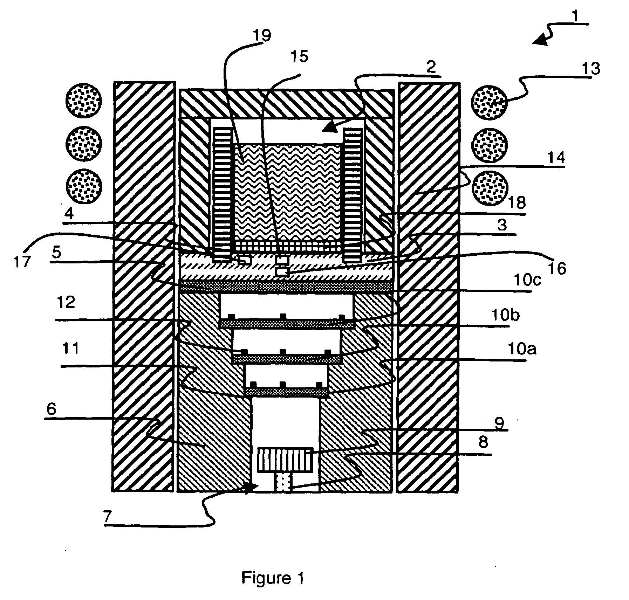

Comme illustré sur la figure 1, le dispositif 1 de fabrication de blocs de matériau cristallin de type Bridgman comporte un creuset 2, comportant lui même un fond 3 et des parois latérales 4. Les matériaux constituant le creuset 2 sont choisis de façon à ce que l'essentiel du flux de chaleur sortant du creuset 2 se fasse par le fond 3. Ainsi, le matériau du fond 3 est, préférentiellement, un bon conducteur thermique comparé aux autres matériaux constituant le creuset 2 afin de pouvoir y extraire l'essentiel du flux de chaleur. Les parois latérales 4 du creuset 2 sont par exemple en silice tandis que le fond 3 du creuset 2 est en graphite. L'épaisseur du fond du creuset est typiquement de quelques centimètres, par exemple 5 cm. Le fond 3 du creuset est avantageusement, au moins partiellement, légèrement fendu sur sa face externe (sur une partie de son épaisseur). La fente, tout en préservant l'étanchéité du fond du creuset, permet d'éviter le couplage inductif dans cette partie du creuset, évitant un échauffement du fond du creuset qui pourrait nuire au germe.

Afin de favoriser une évacuation de la chaleur par conduction, la face externe du fond 3 du creuset 2 est avantageusement recouverte ou solidarisée avec une couche en matériau de conduction 5. Ce matériau de conduction 5 présente une faible émissivité, de préférence inférieure ou égale à 0,5, une conductivité thermique importante, de préférence supérieure à 10 W.m⁻¹.K⁻¹, et est résistant à de hautes températures, typiquement une température supérieure à la température de fusion du matériau à solidifier et encore plus typiquement supérieure à 1400°C. La couche en matériau de conduction 5 est par exemple constituée par un film de molybdène, par exemple, de 1 mm d'épaisseur. Elle favorise ainsi l'extraction de la chaleur contenue dans le creuset 2 par conduction plutôt que par rayonnement.

Le creuset 2 peut présenter par exemple une section carrée, rectangulaire ou ronde. Si un creuset 2 de section carrée est préférentiellement utilisé, ce dernier présente avantageusement des parois latérales 4 de l'ordre de 200 mm de côté. Le creuset 2 peut également présenter des parois latérales jusqu'à 1 m de côté.

Au sein du dispositif 1, le creuset 2 est avantageusement posé sur une couche de conduction 5 de manière à les rendre solidaire, l'ensemble étant alors placé au-dessus de moyens 7 de modulation de la conductivité thermique et de moyens 9 d'extraction de la chaleur contenue dans le creuset 2.

Les moyens 7 de modulation de la conductivité thermique sont interposés entre le fond 3 du creuset 2 et les moyens 9 d'extraction de la chaleur et sont avantageusement situés à l'intérieur d'un support de maintien 6. Les moyens 7 de modulation de la conductivité thermique comportent avantageusement, une pluralité de plaques 10, sous atmosphère contrôlée, et des moyens de déplacement de ces plaques destinés à permettre un rapprochement et un écartement des plaques les unes par rapport aux autres et par rapport au fond du creuset 2. Les moyens de déplacement des plaques 10 comportent, par exemple, une tige de commande 8 sensiblement perpendiculaire au fond 3 du creuset 2 et située le long d'un axe vertical passant par le centre du fond 3 du creuset 2. La tige de commande 8 peut ainsi se mouvoir verticalement selon cet axe vertical.

Les moyens 9 d'extraction de la chaleur sont, par exemple, constitués par un échangeur thermique, avantageusement fixé à l'extrémité supérieure de la tige de commande 8. L'échangeur thermique est, par exemple, constitué par une boîte à eau en cuivre, par exemple, à une température de 27°C.

Le support de maintien 6, situé sous le creuset 2, est avantageusement utilisé pour définir l'écartement maximal autorisé entre chaque plaque et le fond du creuset 2 ainsi qu'entre chacune des plaques 10. Le support de maintien 6 autorise également le déplacement vertical des plaques 10 entre une position d'isolation dans laquelle l'écartement des plaques est maximal et une position de conduction dans laquelle l'écartement des plaques est minimal et prédéfini par des entretoises 12. Le support de maintien 6 est réalisé par tout moyen connu adapté.

Sur la figure 1, le support de maintien 6 comporte, dans une vue en coupe, des parois latérales externes verticales et des parois latérales internes en escaliers présentant des supports plans 11, sensiblement horizontaux de section décroissance, de haut en bas. Ainsi, le support de maintien 6 est plus évasé dans sa partie supérieure que dans sa partie inférieure. Les supports plans 11 définissent les positions les plus éloignées entre les plaques 10 et le fond du creuset 2, c'est-à-dire la position d'isolation des différentes plaques. Dans cette configuration, les plaques 10 ont des sections de dimensions (longueurs et/ou largeurs) décroissantes au fur et à mesure qu'elles sont éloignées du fond du creuset 2. Le support de maintien 6 est préférentiellement en silice frittée et creux. Le creuset 2, la couche de conduction 5 et le support de maintien 6 ont sensiblement le même axe de symétrie vertical.

D'une manière générale, la couche de conduction 5, les moyens d'extraction de la chaleur 9 et les différentes plaques 10 ont la même forme et sensiblement les mêmes dimensions. La forme et les dimensions sont elles-mêmes très proches de celles du creuset et du lingot afin d'assurer une évacuation de la chaleur essentiellement vers le bas et uniformément répartie.

Dans une variante, non représentée, les parois latérales internes sont obliques, délimitant un espace évasé vers le haut pour le positionnement des plaques 10.

Sur la figure 1, trois plaques (10a, 10b et 10c), sensiblement parallèles au fond du creuset 2, reposent sur les supports plans 11 qui servent ainsi de butée de fin de course lors du déplacement des plaques 10 vers le bas. Le déplacement vertical de la tige de commande 8, de bas en haut, entraîne le déplacement vertical des plaques depuis leur position d'isolation jusqu'à leur position de conduction maximale dans laquelle les plaques 10 sont les plus proches possibles du fond du creuset 2.

La couche de conduction 5, les plaques 10 et l'échangeur thermique 9 sont, de préférence, sous une atmosphère contrôlée. Celle-ci comporte au moins un gaz présentant une conductivité thermique supérieure ou égale à une valeur seuil, par exemple 0,01 W/m.K. Ce gaz est par exemple de l'argon ou de l'hélium.

A titre d'exemple, les plaques 10, disposées à l'intérieur du support de maintien 6, sont espacées au maximum de 1 mm, dans leur position d'isolation. Avantageusement, l'espace séparant l'échangeur thermique 9, dans sa position la plus basse, et la plaque la plus basse 10a est le double de l'espace maximal entre deux plaques 10, c'est-à-dire 2 mm.

Les plaques 10 sont rigides et réalisées dans un matériau présentant une conductivité thermique supérieure à 10 W/m.K, une faible émissivité, par exemple de l'ordre de 0,15. Elles sont, par exemple, en molybdène ou en alliage à base de Molybdène. Elles pourraient être également en tungstène ou niobium ou si elles doivent rester à des températures moins élevées, c'est le cas des plaques inférieures, les plus éloignées du creuset, en Tantale, Or, Argent ou Nickel. Ces plaques 10 sont avantageusement polies pour réduire leur émissivité et présentent une pluralité de saillies 12 servant d'entretoises afin d'éviter tout contact entre deux plaques adjacentes en position de conduction. Les saillies 12 peuvent être placées sur les faces supérieures et/ou inférieures des plaques 10. Les saillies 12 sont, par exemple, des petites plaquettes en matériau thermiquement isolant, par exemple en silice. Les saillies 12 peuvent être collées sur les plaques 10 ou insérées dans des cavités creusées dans les plaques 10. Les plaques 10 présentent, par exemple, une épaisseur de l'ordre de 3 mm et des saillies 12 d'une hauteur minimum de l'ordre de 0,1 mm.

L'utilisation d'une pluralité de plaques 10, ayant une faible émissivité, permet de diminuer fortement les échanges par rayonnement. De plus, leur disposition permet de travailler sur de petits volumes de gaz au lieu d'un grand volume. Ainsi, les transferts par convection sont fortement réduits et la résistance thermique du dispositif peut alors se réduire à une résistance de transfert par conduction thermique.

Des moyens de chauffage 13 ainsi que des moyens d'isolation latérale 14 sont illustrés schématiquement sur la figure 1. Les moyens de chauffage 13 sont, par exemple, de type inductif et sont de préférence situés au-dessus et sur les cotés du creuset 2 afin de favoriser le brassage par convection dans la phase liquide. Les moyens d'isolation latérale 14 sont réalisés de manière connue et assurent que le flux de chaleur à extraire est unidirectionnel vers le bas et sensiblement perpendiculaire au plan du fond 3 du creuset 2. Sur la figure 1, ils entourent en totalité le creuset 2, la couche de conduction 5 et le support de maintien 6.

Le dispositif 1 comporte, de plus, des moyens de contrôle de la température comportant au moins trois capteurs de température, par exemple sous forme de thermocouples. Deux capteurs de température sont situés préférentiellement selon l'axe vertical de symétrie du dispositif, un premier capteur 15 étant situé dans la partie supérieure du fond 3 du creuset 2 et un deuxième capteur 16 étant situé dans la partie inférieure du fond 3 du creuset 2. Ces deux capteurs 15, 16 permettent de mesurer le gradient thermique axial dans le creuset 2. Un troisième capteur 17 est situé à la périphérie du fond 3 du creuset 2 et dans sa partie supérieure. Les capteurs 15 et 17 permettent de mesurer le gradient thermique radial au sein du fond 3 du creuset 2.

A titre d'exemple, un procédé d'utilisation du dispositif pour réaliser un lingot de matériau cristallin est décrit ci-dessous. Le matériau cristallin est par exemple du silicium, mais peut être également du germanium ou tout autre matériau cristallin.

Dans un mode de réalisation préférentiel, un germe 18 est avantageusement placé dans le creuset, spécifiquement solidaire du fond 3 du creuset. Le germe 18 est par exemple dans le même matériau que la charge, c'est-à-dire en silicium et d'environ 1 cm d'épaisseur.

Une charge de matériau cristallin est ensuite placée dans le creuset 2. Ce matériau cristallin est préférentiellement de type semi-conducteur, par exemple du silicium. La charge de matériau cristallin est alors fondue par l'actionnement des moyens de chauffage 13, en prenant soin de ne pas fondre le germe 18. Dans cette phase de fusion de la charge de silicium (figure 1), le dispositif est dans un mode d'isolation, c'est-à-dire que les plaques 10 sont portées par les supports plans 11 du support de maintien 6. Dans cette configuration, l'espacement est maximal entre le fond du creuset 3 et les plaques 10 ainsi qu'entre les plaques. L'isolation du creuset par rapport à l'échangeur thermique 9 est ainsi maximale. La tige de commande 8 est alors dans sa position la plus basse, c'est-à-dire que l'échangeur thermique 9 est dans sa position la plus éloignée du creuset 2.

Pendant cette phase de fusion du silicium, la puissance de chauffage augmente, de manière à ce que le front de liquéfaction suive avantageusement une progression verticale descendante vers le germe 18. Une fois que le front de liquéfaction atteint le germe 18, la puissance de chauffage n'évolue plus. Avantageusement, lors de la fusion, une épaisseur de gaz, par exemple d'argon, d'au moins 6 mm est maintenue entre la couche de conduction 5 et l'échangeur thermique 9.

Dans une variante de réalisation, le silicium 19 peut être directement amené dans le creuset sous forme fondue.

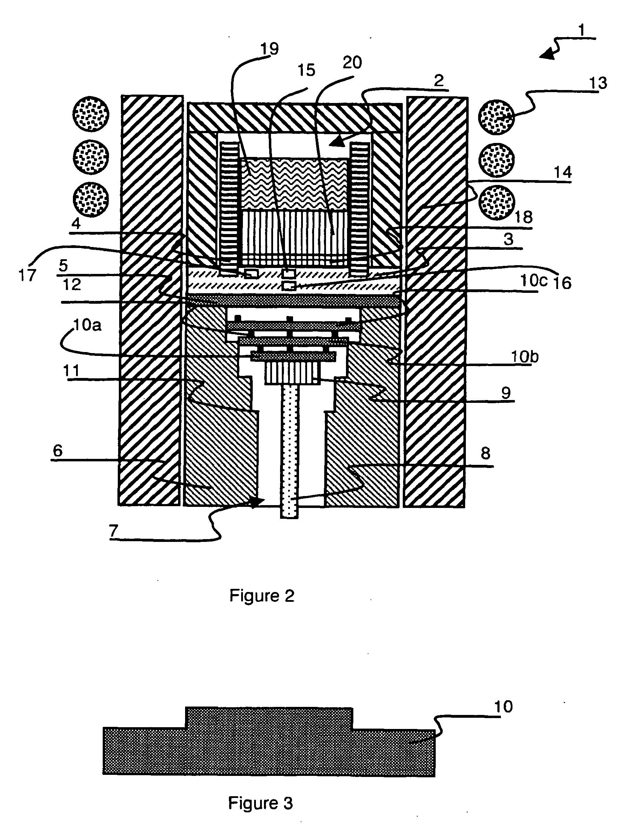

Ensuite, pour initier la croissance sur le germe 18, c'est-à-dire pour inverser le sens de propagation de l'interface entre le silicium solide 20 et le silicium fondu 19, la puissance de chauffage est gardée constante et la translation des plaques 10 commence. En premier lieu, la tige de commande 8, préalablement placée dans sa position inférieure, remonte de manière à rapprocher l'échangeur thermique 9 de la première plaque 10a, la plus basse. La montée de la tige de commande 8 provoque l'entrée en contact de l'échangeur thermique 9 avec la première plaque 10a, puis le déplacement vertical de cette plaque 10a. Comme illustré sur la figure 2, lorsque la translation verticale ascendante de la tige de commande 8 continue, la première plaque 10a se rapproche de la seconde plaque 10b, avec laquelle elle entre en contact au niveau des saillies 12. Les plaques 10 se rapprochent ainsi peu à peu du creuset 2, jusqu'à ce que les saillies 12 de la dernière plaque 10c viennent en contact avec la couche de conduction 5.

La translation de la tige de commande 8 et donc de l'échangeur thermique 9 va permettre de moduler l'épaisseur de la couche de gaz disposée entre l'échangeur thermique 9 et la couche de conduction 5. Ainsi, la translation de la tige de commande 8 permet de moduler la résistance thermique du dispositif 1 sous le creuset 2. Le nombre de plaques 10 à monter pour initier la croissance varie selon le flux de chaleur qu'il faut extraire ainsi que selon les matériaux utilisés (et leurs épaisseurs) au sein du dispositif 1. De cette manière, en rapprochant les plaques 10 du fond 3 du creuset 2, le creuset 2 devient de moins en moins isolant et laisse passer un flux de chaleur plus important que lors de la phase de fusion. Cette approche permet ainsi des évolutions fines et très progressives du flux de chaleur à extraire du creuset 2.

A partir d'un certain stade de solidification du silicium, une diminution de la puissance de chauffage peut être avantageusement couplée à la modulation de la conductivité thermique du fond 3 du creuset 2. De cette manière, la translation de l'échangeur thermique 9 permet de garder une extraction du flux de chaleur constante. La translation permet de diminuer la résistance thermique du dispositif sous le creuset 2 afin de compenser l'augmentation de la résistance thermique due à la partie cristallisée et donc solide du silicium.

Dans l'état final, les plaques 10 seront rapprochées au maximum entre elles et de la couche de conduction 5 et l'épaisseur de gaz totale entre les plaques 10 et entre la couche de conduction 5 et l'échangeur thermique 9 sera minimale. Le dispositif est alors dans un mode de conduction maximale.

Dans une variante de réalisation, si l'épaisseur finale de gaz nécessaire à l'extraction du flux de chaleur recherché est trop faible, un contact direct entre les plaques 10 peut être rendu possible en éliminant les saillies 12 des plaques 10.

Une autre variante de réalisation consiste à réaliser lors de la phase de croissance un changement du gaz présent entre les plaques 10 à l'intérieur du support de maintien 6. Si l'épaisseur de gaz totale est trop faible, un gaz présentant une conductivité thermique plus forte peut être utilisé, par exemple de l'hélium. Ainsi, un espace plus important entre la couche de conduction 5 et l'échangeur thermique 9 peut être utilisé.

Tout au long du procédé de cristallisation du silicium, la température du premier capteur 15 ainsi que la différence de température entre les premier et second capteurs 15, 16 vont permettre de contrôler la puissance de chauffage et le déplacement de la tige de commande 8.

En effet, la puissance de chauffage va évoluer tout au long du processus de cristallisation de manière à ce que la température mesurée par le premier capteur 15 augmente de façon linéaire dans la phase de fusion, puis se stabilise lors de l'initiation de la croissance et enfin diminue linéairement pendant la phase de solidification en lingot.

Dans le même temps, la différence de température entre les premier et second capteurs de température 15 , 16 est liée au déplacement de la tige de commande 8. Ainsi, lors de la phase de fusion de la charge, une différence de température ente les capteurs de température 15, 16 inférieure à un seuil sera recherchée, ce qui se traduira par le fait que le dispositif est dans le mode isolant, c'est-à-dire que la tige de commande 8 se trouve dans sa position la plus basse. Dans la phase d'initiation de la croissance cristalline, la différence de température entre les capteurs 15, 16 va décroître lentement jusqu'à atteindre une seconde valeur seuil. Cette décroissance traduit une extraction du flux de chaleur. Au cours de la solidification, la différence de température entre les capteurs 15, 16 est maintenue constante, malgré l'augmentation de la température mesurée par le premier capteur 15, par le déplacement de la tige de commande 8.

La différence de température entre les capteurs 15 et 17 est représentative du gradient radial au fond du creuset 2 et permet de vérifier que le flux extrait du creuset est bien unidirectionnel. De cette façon, un contrôle de l'isolation radiale est réalisé et une information sur la forme du front de solidification peut être obtenue. Des isothermes sensiblement parallèles au fond du creuset 2 sont préférentiellement choisies de façon à avoir une solidification perpendiculaire au fond du creuset 2.

En variante, une évacuation de chaleur inhomogène peut être recherchée. Si, par exemple, une extraction de chaleur est préférentiellement recherchée au centre du creuset 2, les plaques 10 les plus éloignées du creuset peuvent présenter des dimensions plus faibles que le creuset (comme sur la figure 1). De cette manière, un front de solidification convexe peut être obtenu.

Dans une autre variante de réalisation de l'invention, les plaques 10 présentent des inhomogénéités d'épaisseur. Dans le cas où une extraction de chaleur est recherchée préférentiellement au centre, une surépaisseur de matière peut être utilisée (figure 3). La surépaisseur peut alors être réalisée par toute technique adaptée, par exemple par usinage de la plaque ou par collage de matière, thermiquement conductrice, additionnelle.

La géométrie des plaques est évidemment adaptée afin d'obtenir la distribution recherchée du flux de chaleur.

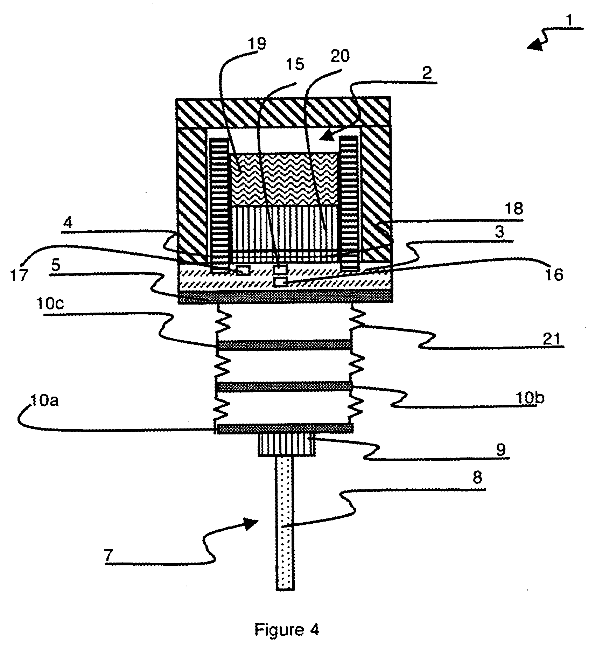

Dans une autre variante de l'invention, illustrée à la figure 4, les plaques 10 peuvent être séparées par des éléments 21 thermiquement isolants, par exemple de type ressort, et présentant une raideur prédéterminée. Ainsi, ces éléments permettent lors du déplacement de la tige de commande 8 le déplacement relatif des plaques entre elles. Les éléments 21 sont avantageusement situés sur la périphérie des plaques 10. Les éléments 21 peuvent alors occuper toute la périphérie des plaques ou alors une pluralité d'éléments sont installés pour occuper des zones prédéterminées.

Avantageusement, des éléments 21 associés aux plaques les plus proches du creuset présentent une raideur plus faibles que les éléments associés aux plaques les plus éloignées.

## Revendications

1. Dispositif de réalisation d'un bloc de matériau cristallin (20) à partir d'un bain de matériau fondu (19), comportant un creuset (2) ayant un fond (3), des moyens d'extraction de la chaleur (9) disposés sous le creuset (2) et des moyens de modulation de la conductivité thermique (7) interposés entre le fond (3) du creuset et les moyens d'extraction de la chaleur (9), dispositif **caractérisé en ce que** les moyens de modulation de la conductivité thermique (7) comportent une pluralité de plaques (10), en matériau thermiquement conducteur et peu émissif, parallèles au fond (3) du creuset et des moyens de rapprochement et d'écartement desdites plaques (10) les unes par rapport aux autres et par rapport au fond du creuset (2), les plaques présentant une émissivité inférieure à 0,5.

2. Dispositif selon la revendication 1, **caractérisé en ce que** les plaques (10) présentent une conductibilité thermique supérieure ou égale à 10 W/m.K.

3. Dispositif selon l'une des revendications 1 et 2, **caractérisé en ce que** les plaques (10) sont en matériau à base de molybdène.

4. Dispositif selon l'une quelconques des revendications 1 à 3, **caractérisé en ce que** les plaques (10) présentent une surépaisseur.

5. Dispositif selon l'une quelconque des revendications 1 à 4, **caractérisé en ce que** les moyens de modulation de la conductivité thermique (7) comportent une atmosphère contrôlée comportant au moins un gaz ayant une conductivité thermique supérieure ou égale à 0,01 W/m.K.

6. Dispositif selon la revendication 5, **caractérisé en ce que** l'atmosphère contrôlée comporte de l'hélium ou de l'argon.

7. Dispositif selon l'une quelconque des revendications 1 à 6, **caractérisé en ce que** les moyens de modulation de la conductibilité thermique comporte une couche de conduction (5) solidaire du fond du creuset et présentant une émissivité inférieure à 0,5.

8. Dispositif selon l'une quelconque des revendications 1 à 7, **caractérisé en ce que** la couche de conduction (5) présente une conductivité thermique supérieure ou égale à 10 W/m.K.

9. Dispositif selon l'une quelconque des revendications 1 à 8, **caractérisé en ce que** les plaques (10) sont munies de saillies 12 constituant des entretoises.

10. Dispositif selon l'une quelconque des revendications 1 à 9, **caractérisé en ce qu'**il comporte, entre les plaques (10), des éléments (21) thermiquement isolants de type ressort.

11. Dispositif selon l'une quelconque des revendications 1 à 10, **caractérisé en ce que** les moyens de rapprochement et d'écartement comportent une tige de commande (8) solidaire des moyens d'extraction de la chaleur (9).

## Claims

1. A device for producing a block of crystalline material (20) from a bath of molten material (19), comprising a crucible (2) having a bottom (3), heat extraction means (9) arranged under the crucible (2), and means for modulating the thermal conductivity (7) fitted between the bottom (3) of the crucible and the heat extraction means (9), a device **characterized in that** the means for modulating the thermal conductivity (7) comprise a plurality of plates (10) made from low emissivity thermally conducting material, parallel to the bottom (3) of the crucible, and means for moving said plates (10) towards and away from one another and towards and away from the bottom of the crucible (2), the plates (10) presenting an emissivity of less than 0.5.

2. The device according to claim 1, **characterized in that** the plates (10) present a thermal conductibility greater than or equal to 10 W/m.K.

3. The device according to one of claims 1 and 2, **characterized in that** the plates (10) are made from molybdenum-based material.

4. The device according to any one of claims 1 to 3, **characterized in that** the plates (10) present an additional thickness.

5. The device according to any one of claims 1 to 4, **characterized in that** the means for modulating the thermal conductivity (7) comprise a controlled atmosphere comprising at least one gas having a thermal conductivity greater than or equal to 0.01 W/m.K.

6. The device according to claim 5, **characterized in that** the controlled atmosphere comprises helium or argon.

7. The device according to any one of claims 1 to 6, **characterized in that** the means for modulating the thermal conductivity comprise a conduction layer (5) securedly united to the bottom of the crucible and presenting an emissivity of less than 0.5.

8. The device according to any one of claims 1 to 7, **characterized in that** the conduction layer (5) presents a thermal conductivity greater than or equal to 10 W/m.K.

9. The device according to any one of claims 1 to 8, **characterized in that** the plates (10) are provided with protuberances (12) forming spacers.

10. The device according to any one of claims 1 to 9, **characterized in that** it comprises thermally insulating elements (21) of spring type between the plates (10).

11. The device according to any one of claims 1 to 10, **characterized in that** the means for moving the plates towards and away from one another comprise a control rod (8) integral to the heat extraction means (9).

## Patentansprüche

1. Vorrichtung zur Herstellung eines Blocks aus kristallinem Material (20) aus einem Bad mit geschmolzenem Material (19), umfassend einen Schmelztiegel (2), welcher einen Boden (3) aufweist, Mittel zum Abführen der Wärme (9), welche unterhalb des Schmelztiegels (2) angeordnet sind, und Mittel zum Modulieren der Wärmeleitfähigkeit (7), welche zwischen dem Boden (3) des Schmelztiegels (2) und dem Mittel zum Abführen der Wärme (9) angeordnet sind, wobei die Vorrichtung **dadurch gekennzeichnet ist, dass** die Mittel zum Modulieren der Wärmeleitfähigkeit (7) eine Vielzahl von Platten (10) aus einem thermisch leitenden Material und wenig strahlend parallel zum Boden (3) des Schmelztiegels und Mittel zum Annähern und Beabstanden der besagten Platten (10) umfassen, die einen bezogen auf die anderen und bezogen auf den Boden des Schmelztiegels (2), wobei die Platten ein Emissionsvermögen kleiner als 0,5 aufweisen.

2. Vorrichtung gemäß Anspruch 1, **dadurch gekennzeichnet, dass** die Platten (10) eine thermische Leitfähigkeit größer als oder gleich zu 10 W/m.K aufweisen.

3. Vorrichtung gemäß einem der Ansprüche 1 oder 2, **dadurch gekennzeichnet, dass** die Platten (10) aus einem Material auf der Basis von Molybdän sind.

4. Vorrichtung gemäß irgendeinem der Ansprüche 1 bis 3, **dadurch gekennzeichnet, dass** die Platten (10) eine Verdickung aufweisen.

5. Vorrichtung gemäß irgendeinem der Ansprüche 1 bis 4, **dadurch gekennzeichnet, dass** die Mittel zur Modulation der thermischen Leitfähigkeit (7) eine kontrollierte Atmosphäre umfassen, welche zumindest ein Gas umfasst, welches eine thermische Leitfähigkeit größer oder gleich zu 0,01 W/m.K aufweist.

6. Vorrichtung gemäß Anspruch 5, **dadurch gekennzeichnet, dass** die kontrollierte Atmosphäre Helium oder Argon umfasst.

7. Vorrichtung gemäß irgendeinem der Ansprüche 1 bis 6, **dadurch gekennzeichnet, dass** die Mittel zur Modulation der thermischen Leitfähigkeit eine leitende Schicht (5) umfassen, welche mit dem Boden des Schmelztiegels verbunden ist und ein Emissionsvermögen kleiner als 0,5 aufweist.

8. Vorrichtung gemäß irgendeinem der Ansprüche 1 bis 7, **dadurch gekennzeichnet, dass** die leitende Schicht (5) eine thermische Leitfähigkeit größer als oder gleich zu 10 W/m.K aufweist.

9. Vorrichtung gemäß irgendeinem der Ansprüche 1 bis 8, **dadurch gekennzeichnet, dass** die Platten (10) mit Vorsprüngen 12 versehen sind, welche Abstandshalter bilden.

10. Vorrichtung gemäß irgendeinem der Ansprüche 1 bis 9, **dadurch gekennzeichnet, dass** sie zwischen den Platten (10) Elemente (21) des Federtyps, welche thermisch isolierend sind, umfasst.

11. Vorrichtung gemäß irgendeinem der Ansprüche 1 bis 10, **dadurch gekennzeichnet, dass** die Mittel zum Annähern und Beabstanden eine Steuerstange (8) umfassen, welche mit den Mitteln zum Abführen der Wärme (9) verbunden ist.
